(19) Europäisches Patentamt
European Patent Office
Office européen des brevets

(11) EP 0 762 206 B1

(12) EUROPÄISCHE PATENTSCHRIFT

(45) Veröffentlichungstag und Bekanntmachung des Hinweises auf die Patenterteilung:
**30.01.2002 Patentblatt 2002/05**

(51) Int Cl.[7]: **G03F 7/004**, G03F 7/039

(21) Anmeldenummer: **96114059.7**

(22) Anmeldetag: **03.09.1996**

(54) **Positivarbeitendes strahlungsempfindliches Gemisch und Verfahren zur Herstellung von Reliefstrukturen**

Positive working photosensitive composition and method of producing relief structures

Composition photosensible positive et procédé de fabrication de structures en relief

(84) Benannte Vertragsstaaten:
**BE DE FR GB IT NL**

(30) Priorität: **11.09.1995 DE 19533607**

(43) Veröffentlichungstag der Anmeldung:
**12.03.1997 Patentblatt 1997/11**

(73) Patentinhaber: **BASF AKTIENGESELLSCHAFT**
**67056 Ludwigshafen (DE)**

(72) Erfinder:
- **Schwalm, Reinhold, Dr.**
  **67157 Wachenheim (DE)**
- **Funhoff, Dirk, Dr.**
  **69469 Weinheim (DE)**
- **Binder, Horst**
  **68623 Lampertheim (DE)**

(56) Entgegenhaltungen:
**EP-A- 0 628 876** **DE-A- 4 306 069**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 762 206 B1

## Beschreibung

Die Erfindung betrifft positiv arbeitende strahlungsempfindliche Gemische, die säurelabile Gruppierungen und photoaktive Komponenten enthalten, sensitiv gegenüber aktinischer Strahlung sind und verbesserten Kontrast aufweisen. Diese strahlungsempfindlichen Gemische eignen sich besonders als Resistmaterialien für Einlagenresiste zur Herstellung von Reliefmustern.

Positiv arbeitende strahlungsempfindliche Gemische, die auf dem Prinzip der "chemischen Verstärkung" beruhen, sind an sich bekannt. Dabei wird in einer Primärphotoreaktion eine Spezies erzeugt, die dann unabhängig von der Strahlung eine katalytische Sekundärreaktion auslöst und dadurch die Empfindlichkeit drastisch erhöht. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.

Der Kontrast derartiger Resiste, d.h. die "Schärfe" bei der Differenzierung zwischen unbelichteten und belichteten Bereichen ist eine wichtige anwendungstechnische Größe. Daher sind Verfahren zur Verbesserung des Kontrasts immer gesucht.

Aufgabe der vorliegenden Erfindung ist es, ein strahlungsempfindliches Gemisch aufzuzeigen, das sehr gute Lichtempfindlichkeit, guten Verarbeitungsspielraum, keinen Schichtdickenverlust zwischen den verschiedenen Prozeßschritten und Reliefstrukturen mit verbessertem Kontrast ergibt.

Diese Aufgabe läßt sich überraschenderweise durch die erfindungsgemäßen positiv arbeitenden strahlungsempfindlichen Gemische lösen.

Gegenstand der vorliegenden Erfindung sind

Positiv arbeitende strahlungsempfindliche Gemische im wesentlichen bestehend aus

(a) mindestens einem säurelabile Gruppierungen enthaltenden Polymeren, das in Wasser unlöslich, durch Einwirkung von Säure in wäßrig-alkalischen Lösungen löslich wird,

(b) mindestens einer organischen Verbindung, welche unter Einwirkung von aktinischer Strahlung eine Säure erzeugt, sowie

(c) mindestens einer weiteren von (b) verschiedenen organischen Verbindung,

die dadurch gekennzeichnet sind, daß
das Polymere (a) Einheiten der Formeln (I), (II) und (III)

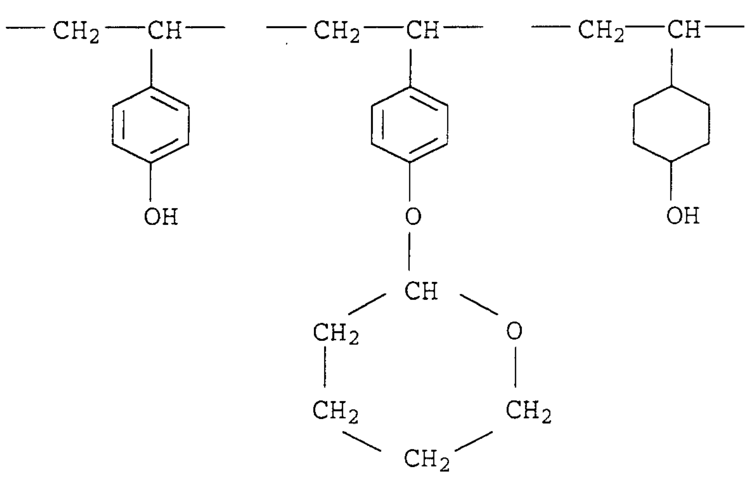

(I) (II) (III)

eingebaut enthält, mit der Maßgabe, daß

35-70 mol% Einheiten der Formel (I)
30-50 mol% Einheiten der Formel (II)und
0-15 mol% Einheiten der Formel (III)

als Struktureinheiten des Polymeren enthalten sind,
die organische Verbindung (b) ein Sulfoniumsalz der Formel (IV)

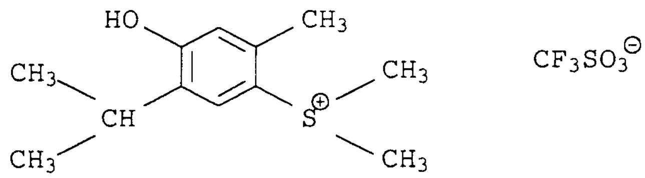

(IV)

ist und die organische Verbindung (c) der Formel (V)

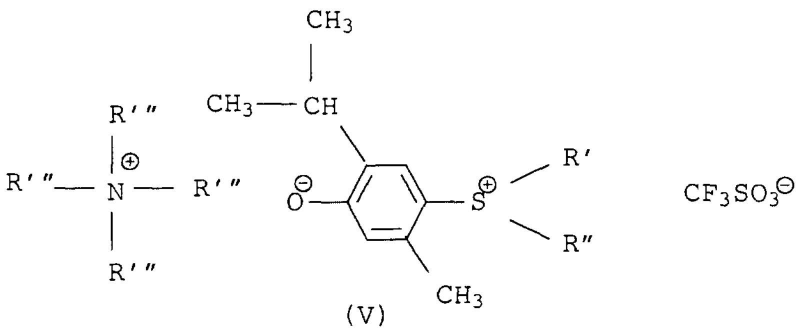

(V)

entspricht, worin R' und R" untereinander gleich oder verschieden sind und für Alkylreste mit 1 bis 4 Kohlenstoffatomen stehen oder R' mit R" miteinander über $CH_2$-Gruppen zu einem fünfgliedrigen Ring verknüpft sind, und R'" für einen Alkylrest mit 1 bis 4 Kohlenstoffatomen steht.

Bevorzugt ist, wenn in Formel (V) der organischen Verbindung (c) R', R" und R'" für $CH_3$ stehen.

Die erfindungsgemäßen Gemische liegen vorzugsweise in Form einer Lösung in einem organischen Lösungsmittel oder Lösungsmittelgemisch vor. Bevorzugt ist außerdem, daß die Komponenten (a), (b), und (c) in Mengen

von 90 bis 97,99 Gewichtsprozent (a),
von 2 bis 8 Gewichtsprozent (b) und
von 0,01 bis 2 Gewichtsprozent (c),

jeweils bezogen auf die Gesamtmischung (a)+(b)+(c), eingesetzt werden.

Gegenstand der vorliegenden Erfindung ist auch ein Verfahren zur Herstellung lichtempfindlicher Beschichtungsmaterialien, wobei erfindungsgemäße strahlungsempfindliche Gemische eingesetzt werden.

Gegenstand der vorliegenden Erfindung ist insbesondere auch ein Verfahren zur Herstellung von Reliefstrukturen durch Auftragen eines strahlungsempfindlichen Gemischs in einer Schichtdicke von 0,1 bis 5 µm auf ein in üblicher Weise vorbehandeltes Substrat, Trocknen bei Temperaturen von 70 bis 150°C, bildmäßiges Belichten mit aktinischem Licht, gegebenenfalls Erhitzen auf Temperaturen von 40 bis 160°C, und Entwickeln mit einer wäßrig-alkalischen Lösung, wobei strahlungsempfindliche Gemische gemäß der vorliegenden Erfindung eingesetzt werden.

Die erfindungsgemäßen strahlungsempfindlichen Gemische zeichnen sich durch geringe Absorption der UV-Strahlung aus und ergeben daher steile Flanken im Relief und sie weisen sehr gute Lichtempfindlichkeit (ca. 30 mJ/$cm^2$) auf, so daß sie sehr gut für die Verarbeitung in Deep-UV-Steppern geeignet sind. Weitere sehr wesentliche Vorteile sind, daß Kontrast und "Depth of Focus" verbessert sind, so daß Strukturen von 0,25 µm auch bei Schichtdickenschwankungen reproduzierbar hergestellt werden können.

Besonders vorteilhaft ist der sehr gute Verarbeitungsspielraum der belichteten Wafer, so daß diese selbst noch nach einer Stunde nach ihrer Belichtung reproduzierbar strukturiert werden können, sowie daß kein Schichtdickenverlust zwischen den verschiedenen Prozeßschritten, wie Ausheizen und Entwickeln, eintritt.

Zu den Aufbaukomponenten der erfindungsgemäßen strahlungsempfindlichen Gemische ist im einzelnen folgendes auszuführen.

Die erfindungsgemäß einzusetzenden Polymeren (a) weisen im allgemeinen Molekulargewichte ($\overline{M}_w$) zwischen 2000 und 100000, vorzugsweise zwischen 4000 und 30000 auf und lassen sich beispielsweise aus Poly-(p-hydroxystyrol) oder vorzugsweise zusätzlich nichtaromatische cyclische Alkoholeinheiten (Vinylcyclohexanol-4-Einheiten) in Mengen bis zu 15 mol% enthaltendem Poly-(p-hydroxystyrol), z.B. durch polymeranaloge Umsetzung mit entsprechenden Mengen Tetrahydropyran in Gegenwart von Säure herstellen. Ein entsprechendes Verfahren kann der EP-342 498-B (DE-A-3 817 012) entnommen werden.

Als Ausgangsprodukte zur Herstellung der erfindungsgemäß einzusetzenden Polymeren (a) eignen sich beispielsweise auch solche, teilweise hydrierte Poly-(p-hydroxystyrole), wie sie der J 01 103 604-A und der EP-A-0 401 499 entnommen werden können.

Das Polymere (a) enthält die Einheiten der Formeln (I), (II) und (III) in Mengen von

35-70 mol% Einheiten der Formel (I),
30-50 mol% Einheiten der Formel (II) und
0-15 mol% Einheiten der Formel (III) eingebaut.

Sofern das Polymere (a) keine Einheiten der Formel (III) eingebaut enthält, sind vorzugsweise 50-70 mol% Einheiten der Formel (I) und 30-50 mol% Einheiten der Formel (II) als Struktureinheiten eingebaut.

Besonders bevorzugt enthält jedoch das Polymere (a) Einheiten der Formel (III) in Mengen von 2 bis 15 mol%, vorzugsweise 6 bis 14 mol%, bezogen auf die Gesamtmenge der Struktureinheiten der Formeln (I), (II) und (III) in mol%, als Struktureinheiten eingebaut. In diesem Fall enthält das Polymer (a) in aller Regel 37-60 mol%, und insbesondere 38-58 mol%, der Struktureinheiten der Formel (I) und 38-48 mol% der Struktureinheiten der Formel (II) eingebaut.

Komponente (a) ist im erfindungsgemäßen strahlungsempfindlichen Gemisch im allgemeinen in Mengen von 90 bis 97,99, vorzugsweise 93 bis 96 Gewichtsprozent, bezogen auf die Gesamtmenge der Komponenten (a) + (b) + (c), enthalten.

Als organische Verbindung (b), welche unter Einwirkung von aktinischer Strahlung eine Säure erzeugt, wird erfindungsgemäß ein Sulfoniumsalz der Formel (IV) eingesetzt. Die Herstellung von Sulfoniumsalzen ist Stand der Technik. Sie kann beispielsweise nach einer in J. Polym. Sci., Chem. Ed., 18, 1021 (1980) beschriebenen Synthesevorschrift erfolgen. Die organische Verbindung (b) ist im erfindungsgemäßen strahlungsempfindlichen Gemisch im allgemeinen in einer Menge von 2 bis 8, vorzugsweise 3 bis 6 Gewichtsprozent, bezogen auf die Gesamtmenge der Komponenten (a) + (b) + (c) enthalten.

Die erfindungsgemäß als Komponente (c) einzusetzende organische Verbindung entspricht der Formel (V), worin R', R'' und R''' untereinander gleich oder verschieden sind und für Alkylreste mit 1 bis 4 Kohlenstoffatomen, wie z.B. Methyl-, Ethyl-, Propyl-, Isopropyl-, n-Butyl- oder Isobutylreste stehen oder R' mit R'' miteinander über $CH_2$-Gruppen zu einem fünfgliedrigen Ring verknüpft sind. Vorzugsweise stehen R', R'' und R''' für $CH_3$.

Die Herstellung derartiger Verbindungen (c) kann beispielsweise durch Umsetzung eines 2-Methyl-4-hydroxy-5-isopropyl-phenyl-dialkylsulfoniumtriflats mit etwa äquimolaren Mengen Tetramethylammoniumhydroxid erfolgen, beispielsweise in Gegenwart von inertem Lösungsmittel, wie z.B. in Alkanolen.

Komponente (c) ist im erfindungsgemäßen strahlungsempfindlichen Gemisch im allgemeinen in Mengen von 0,01 bis 2, vorzugsweise 0,05 bis 1 Gewichtsprozent, bezogen auf die Gesamtmenge der Komponenten (a) + (b) + (c) enthalten.

Das erfindungsgemäße strahlungsempfindliche Gemisch kann zusätzlich noch weitere, dem Stand der Technik entsprechende, übliche Hilfs- und Zusatzstoffe (Sensibilisatoren, Farbstoffe, Verlaufshilfsmittel, Netzhilfsmittel, Stabilisatoren usw.) enthalten. Diese Zusatzstoffe werden im allgemeinen in Mengen kleiner 3 Gew.-%, bezogen auf die Gesamtmenge der Komponenten (a)+(b)+(c), zugesetzt.

Die erfindungsgemäßen Gemische werden zur Herstellung von Resists bevorzugt in einem geeigneten inerten polaren organischen Lösungsmittel gelöst, wobei der Feststoffgehalt üblicherweise im Bereich zwischen 5 und 40 Gew.-% liegt. Als Lösungsmittel kommen im Prinzip aliphatische Ketone, Alkohole, Ether und Ester, sowie Mischungen derselben in Frage. Besonders bevorzugt sind Alkylenglykol-monoalkylether, wie beispielsweise Ethylcellosolve, Butylglykol, Methylcellosolve und 1-Methoxy-2-propanol, Alkylenglykolalkylether-ester, wie beispielsweise Methylcellosolveacetat, Methylpropylenglykolacetat und Ethylpropylenglykolacetat, Ketone, wie beispielsweise Cyclohexanon, Cyclopentanon und Methylethylketon, sowie Acetate wie Butylacetat, Ethylacetat, andere Ester, wie Ethyllactat und Butyrolacton sowie deren Gemische mit Aromaten wie Toluol und Xylol. Die Auswahl der entsprechenden Lösungsmittel, sowie deren Mischungen richtet sich nach der Löslichkeit des Gemisches der jeweiligen Komponenten (a) + (b) + (c).

Weiterhin können andere Zusätze wie Haftvermittler und Weichmacher zugesetzt werden, im allgemeinen in Mengen von bis zu 1 Gew.-%.

Die erfindungsgemäßen strahlungsempfindlichen Gemische sind sensitiv gegenüber Röntgen-, Elektronen-

und UV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen.

Bei dem erfindungsgemäßen Verfahren zur Herstellung von lichtempfindlichen Beschichtungsmaterialien und zur Herstellung von positiven Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 40 und 160°C in wäßrig-alkalischen Lösungsmitteln zunimmt und diese Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 150°C) und mit einer geeigneten Lichtquelle durch eine Photomaske bildmäßig belichtet, z.B. mit kurzwelligen UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 160°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 10 und 300 $mJ/cm^2$ bei Schichtdicken von 1 µm.

Die erfindungsgemäßen strahlungsempfindlichen Gemische zeichnen sich durch hohe Empfindlichkeit, gute Auflösung, verbesserten Kontrast, verbesserten Depth of Focus und vergrößerten Verarbeitungsspielraum aus und eignen sich daher besonders vorteilhaft für die Lithographie im kurzwelligen Bereich.

Die in den Beispielen und Vergleichsbeispielen genannten Teile und Prozente sind, soweit nicht anders angegeben, Gewichtsteile bzw. Gewichtsprozente.

Die Bestimmung des "Depth of Focus" erfolgte analog der von Chris A. Mack in Microlithography World, Spring 1995, Seiten 20 bis 21, U.S.A. beschriebenen Methode.

Der Kontrast des Resists, ausgedrückt mittels des Gamma-Wertes ($\Gamma_p$), wurde aus einer Auftragung von Schichtdicke gegen Belichtungsdosis ermittelt. Für Positiv-Resistsysteme ist der Gamma-Wert definiert als

$$\Gamma_p = [\log \frac{D_1}{D_0}]^{-1}$$

wobei $D_0$ und $D_1$ die extrapoliserten Belichtungsenergiedosen aus der Dunkelabtragsenergiekurve darstellen.

Vergleichsbeispiel 1

Eine Photoresistlösung wurde aus 5 Teilen
2-Methyl-4-hydroxy-5-isopropyl-phenyl-dimethylsulfoniumtriflat und 95 Teilen Poly-[4-hydroxystyrol-co-4-tetrahydropyranyloxystyrol-co-vinylcyclohexanol-4] (molares Verhältnis der Comonomeren = 49:45:6) und 400 Teilen Ethyllaktat hergestellt. Nach Auflösen der Einsatzstoffe wurde diese Lösung durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 min bei 130°C ausgeheizt. Nach der Belichtung durch eine strukturierte Testmaske mit Excimer-Laserlicht der Wellenlänge 248 nm wurde der Wafer bei 130°C für 1 min ausgeheizt und danach mit einem wäßrig-alkalischen Entwickler 1 min entwickelt.

Nach Messung der zurückgebliebenen Photolackschichten wurde der Kontrast des Resistes ermittelt. Es ergab sich ein Gamma-Wert von 6.

Beispiel 1

Eine Photoresistlösung wurde aus 5 Teilen
2-Methyl-4-hydroxy-5-isopropyl-phenyl-dimethylsulfoniumtriflat, 0,1 Teilen der organischen Verbindung (c) der Formel (V), worin R', R" und R"' Methylgruppen sind, und 95 Teilen Poly-[4-hydroxystyrol-co-4-tetrahydropyranyloxystyrol-co-vinylcyclohexanol-4] (molares Verhältnis der Comonomeren = 49:45:6) und 400 Teilen Ethyllaktat hergestellt. Nach Auflösen der Einsatzstoffe wurde diese Lösung durch ein Filter mit einem Porendurchmesser von 0,2 µm filtriert und analog Vergleichsbeispiel 1 verarbeitet. Der gefundene Gamma-Wert dieser Lösung beträgt 8.

Vergleichsbeispiel 2

Eine Photoresistlösung wurde aus 5 Teilen 2-Methyl-4-hydroxy-5-isopropyl-phenyl-dimethylsulfoniumtriflat und 95 Teilen Poly-[4-hydroxystyrol-co-4-tetrahydropyranyloxystyrol-co-vinylcyclohexanol-4] (molares Verhältnis der Comonomeren = 52:40:8) und 400 Teilen Ethyllaktat hergestellt. Nach Auflösen der Einsatzstoffe wurde diese Lösung durch ein Filter mit einem Porendurchmesser von 0,2 µm filtriert.

Nach der Verarbeitung gemäß Beispiel 1 wurde ein Gamma-Wert von 6,5 experimentell ermittelt.

Beispiel 2

Eine Photoresistlösung wurde aus 5 Teilen 2-Methyl-4-hydroxy-5-isopropyl-phenyl-dimethylsulfoniumtriflat, 0,1 Teilen der organischen Verbindung (c) der Formel (V), worin R', R" und R'" Methylgruppen sind, und 95 Teilen Poly-[4-hydroxystyrol-co-4-tetrahydropyranyloxystyrol-co-vinylcyclohexanol-4] (molares Verhältnis der Comonomeren = 52:40:8) und 400 Teilen Ethyllaktat hergestellt. Nach der Verarbeitung gemäß Beispiel 1 wurde ein Gamma-Wert von 9 experimentell ermittelt.

Vergleichsbeispiel 3

Eine Photoresistlösung wurde aus 6 Teilen 2-Methyl-4-hydroxy-5-isopropyl-phenyl-dimethylsulfoniumtriflat und 94 Teilen Poly-[4-hydroxystyrol-co-4-tetrahydropyranyloxystyrol-co-vinylcyclohexanol-4] (molares Verhältnis der Comonomeren = 47:40:13) und 400 Teilen Ethyllaktat hergestellt. Nach Auflösen der Einsatzstoffe wurde diese Lösung durch ein Filter mit einem Porendurchmesser von 0,2 µm filtriert.

Nach der Verarbeitung gemäß Beispiel 1 wurde ein Gamma-Wert von 6,5 experimentell ermittelt.

Beispiel 3

Eine Photoresistlösung wurde aus 6 Teilen 2-Methyl-4-hydroxy-5-isopropyl-phenyl-dimethylsulfoniumtriflat, 0,1 Teilen der organischen Verbindung (c) der Formel (V), worin R', R" und R'" Methylgruppen sind, und 94 Teilen Poly-[4-hydroxystyrol-co-4-tetrahydropyranyloxystyrol-co-vinylcyclohexanol-4] (molares Verhältnis der Comonomeren = 47:40:13) und 400 Teilen Ethyllaktat hergestellt. Nach der Verarbeitung gemäß Beispiel 1 wurde ein Gamma-Wert von 10 experimentell ermittelt.

Vergleichsbeispiel 4

Eine Photoresistlösung wurde aus 5 Teilen 2-Methyl-4-hydroxy-5-isopropyl-phenyl-dimethylsulfoniumtriflat und 95 Teilen Poly-[4-hydroxystyrol-co-4-tetrahydropyranyloxystyrol-co-vinylcyclohexanol-4] (molares Verhältnis der Comonomeren = 42:45:13) und 345 Teilen Ethyllaktat hergestellt. Nach Auflösen der Einsatzstoffe wurde diese Lösung durch ein Filter mit einem Porendurchmesser von 0,2 µm filtriert.

Von dieser Lösung wurde ein ca. 1 µm dicke Resistschicht auf oberflächlich oxidierte Siliziumwafer aufgeschleudert.

Nach der weiteren Verarbeitung gemäß Beispiel 1 wurde ein Gamma-Wert von 7,5 experimentell ermittelt.

Beispiel 4

Eine Photoresistlösung wurde aus 5 Teilen 2-Methyl-4-hydroxy-5-isopropyl-phenyl-dimethylsulfoniumtriflat, 0,15 Teilen der organischen Verbindung (c) der Formel (V), worin R', R" und R'" Methylgruppen sind, und 95 Teilen Poly-[4-hydroxystyrol-co-4-tetrahydropyranyloxystyrol-co-vinylcyclohexanol-4] (molares Verhältnis der Comonomeren = 42:45:13) und 400 Teilen Ethyllaktat hergestellt. Nach der Verarbeitung gemäß Beispiel 1 wurde ein Gamma-Wert von 12 experimentell ermittelt.

Vergleichsbeispiel 5

Eine Photoresistlösung wurde aus 4 Teilen 2-Methyl-4-hydroxy-5-isopropyl-phenyl-dimethylsulfoniumtriflat und 96 Teilen Poly-[4-hydroxystyrol-co-4-tetrahydropyranyloxystyrol-co-vinylcyclohexanol-4] (molares Verhältnis der Comonomeren = 49:38:13) und 400 Teilen Ethyllaktat hergestellt. Nach Auflösen der Einsatzstoffe wurde diese Lösung durch ein Filter mit einem Porendurchmesser von 0,2 µm filtriert.
Nach der weiteren Verarbeitung gemäß Beispiel 1 wurde ein Gamma-Wert von 6,4 experimentell ermittelt.

Beispiel 5

Eine Photoresistlösung wurde aus 4 Teilen 2-Methyl-4-hydroxy-5-isopropyl-phenyl-dimethylsulfoniumtriflat, 0,15 Teilen der organischen Verbindung (c) der Formel (V), worin R', R" und R' " Methylgruppen sind, und 96 Teilen Poly-[4-hydroxystyrol-co-4-tetrahydropyranyloxystyrol-co-vinylcyclohexanol-4] (molares Verhältnis der Comonomeren = 49:38:13) und 400 Teilen Ethyllaktat hergestellt. Nach der Verarbeitung gemäß Beispiel 1 wurde ein Gamma-Wert von 9 experimentell ermittelt.
Die erfindungsgemäß beanspruchten Zusätze in den Beispielen 1, 2, 3, 4, 5 bringen bessere Eigenschaften des untersuchten Photoresists.
Diese verbesserten Eigenschaften können weiterhin bei der Messung der Depth of Focus festgestellt werden.
Der erfindungsgemäß beanspruchte Zusatz verbessert den Depth of Focus, was zu einem größeren Verarbeitungsspielraum führt.

Beispiel 6

Eine Photoresistlösung, hergestellt nach Beispiel 1, wurde auf einem mit einem ca. 100 nm dicken Antireflecting-Coating (z.B. ARC® CD9 der Fa. Brewer Science, Inc. Rolla, MO, U.S.A.) beschichteten Siliziumwafer (Durchmesser 200 mm) in einer Schichtdicke von 700 nm aufgetragen und bei 130°C ausgeheizt.
Nach der Belichtung mit einem Waferstepper der Firma ASM Lithography mit unterschiedlichen Focustiefen wurde der Wafer ausgeheizt und in einem Sprühentwickler mit einem wäßrig-alkalischen Medium entwickelt.
Zur Bestimmung der Depth of Focus wurden die Linienbreiten bei unterschiedlichem Focus ausgemessen. Folgende Resultate wurden erhalten:

| Focus [µm] | Linienbreite [nm] |
|---|---|
| -0,8 | 404 |
| -0,6 | 327 |
| -0,4 | 332 |
| -0,2 | 338 |
| 0 | 348 |
| 0,2 | 358 |
| 0,4 | 362 |
| 0,6 | 355 |
| 0,8 | 345 |
| 1,0 | 345 |
| 1,2 | 344 |
| 1,4 | 405 |

Eine Vergleichsprobe entsprechend Vergleichsbeispiel 1 ohne den erfindungsgemäßen Zusatz der Komponente (c) zeigte dagegen schlechtere Ergebnisse:

| Focus [µm] | Linienbreite [nm] |
|---|---|
| -0,8 | 497 |

(fortgesetzt)

| Focus [µm] | Linienbreite [nm] |
|---|---|
| -0,6 | 371 |
| -0,4 | 341 |
| -0,2 | 345 |
| 0 | 348 |
| 0,2 | 353 |
| 0,4 | 355 |
| 0,6 | 355 |
| 0,8 | 352 |
| 1,0 | 372 |
| 1,2 | 395 |

Vergleichsbeispiel 7

Eine weitere Resistformulierung aus 3 Teilen 2-Methyl-4-hydroxy-5-isopropyl-phenyl-dimethylsulfoniumtriflat und 97 Teilen Poly-[4-hydroxystyrol-co-4-tetrahydropyranyloxystyrol-co-vinylcyclohexanol-4] (molares Verhältnis der Comonomeren = 46:45:9) und 400 Teilen Ethyllaktat wurde entsprechend Beispiel 6 verarbeitet. Ausgemessen wurden die Linien mit 250 nm breiten Strukturen

| Focus [µm] | Linienbreite [nm] |
|---|---|
| -0,6 | 200 |
| -0,4 | 231 |
| -0,2 | 231 |
| 0 | 221 |
| 0,2 | 213 |
| 0,4 | nicht messbar |
| 0,6 | nicht messbar |

Beispiel 7

Der Resistformulierung von Vergleichsbeispiel 7 wurden 0,1 Teile der organischen Verbindung (c) der Formel (V), worin R', R'' und R''' Methylgruppen sind, zugemischt. Damit lassen sich gegenüber Vergleichsbeispiel 7 deutlich bessere Ergebnisse erzielen:

| Focus [µm] | Linienbreite [nm] |
|---|---|
| -0,6 | 207 |
| -0,4 | 229 |
| -0,2 | 334 |
| 0 | 238 |
| 0,2 | 235 |
| 0,4 | 225 |
| 0,6 | 226 |
| 0,8 | 352 |

Vergleichsbeispiel 8

Eine Photoresistlösung wurde aus 5 Teilen 2-Methyl-4-hydroxy-5-isopropyl-phenyl-dimethylsulfoniumtriflat und 95 Teilen Poly-[4-hydroxystyrol-co-4-tetrahydropyranyloxystyrol] (molares Verhältnis der Comonomeren = 60:40) und 400 Teilen Ethyllaktat hergestellt. Nach Auflösen der Einsatzstoffe wurde diese Lösung durch eine Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 min bei 130°C ausgeheizt. Nach der Belichtung durch eine strukturierte Testmaske mit Excimer-Laserlicht der Wellenlänge 248 nm wurde der Wafer bei 130°C für 1 min ausgeheizt und danach mit einem wäßrig-alkalischen Entwickler 1 min entwickelt.

Nach Messung der zurückgebliebenen Photolackschichten wurde der Kontrast des Resistes ermittelt. Es ergab sich ein Gamma-Wert von 6,4.

Beispiel 8

Eine Photoresistlösung wurde aus 5 Teilen 2-Methyl-4-hydroxy-5-isopropyl-phenyl-dimethylsulfoniumtriflat, 0,1 Teilen der organischen Verbindung (c) der Formel (V), worin R', R'' und R''' Methylgruppen sind und 95 Teilen Poly-[4-hydroxystyrol-co-4-tetrahydropyranyloxystyrol] (molares Verhältnis der Comonomeren = 60:40) und 400 Teilen Ethyllaktat hergestellt. Nach Auflösen der Einsatzstoffe wurde diese Lösung durch ein Filter mit einem Porendurchmesser von 0,2 µm filtriert und analog Beispiel 1 verarbeitet. Der Gamma-Wert beträgt 7,5.

Vergleichsbeispiel 9

Eine Photoresistlösung wurde aus 4 Teilen 2-Methyl-4-hydroxy-5-isopropyl-phenyl-dimethylsulfoniumtriflat und 96 Teilen Poly-[4-hydroxystyrol-co-4-tetrahydropyranyloxystyrol] (molares Verhältnis der Comonomeren = 59:41) und 400 Teilen Ethyllaktat hergestellt. Nach Auflösen des Einsatzstoffes wurde diese Lösung durch eine Filter mit einem Porendurchmesser von 0,2 µm filtriert.

Nach der Verarbeitung gemäß Beispiel 1 wurde ein Gamma-Wert von 6,5 experimentell ermittelt.

Beispiel 9

Eine Photoresistlösung wurde aus 4 Teilen 2-Methyl-4-hydroxy-5-isopropyl-phenyl-dimethylsulfoniumtriflat, 0,1 Teilen der organischen Verbindung (c) der Formel (V), worin R', R'' und R''' Methylgruppen sind, und 96 Teilen Poly-[4-hydroxystyrol-co-4-tetrahydropyranyloxystyrol] (molares Verhältnis der Comonomeren = 59:41) und 400 Teilen Ethyllaktat hergestellt. Nach der Verarbeitung gemäß Beispiel 1 wurde ein Gamma-Wert von 8,4 experimentell ermittelt.

## Patentansprüche

1. Positiv arbeitendes strahlungsempfindliches Gemisch im wesentlichen bestehend aus

   (a) mindestens einem säurelabile Gruppierungen enthaltenden Polymeren, das in Wasser unlöslich, durch Einwirkung von Säure in wäßrig-alkalischen Lösungen löslich wird,

   (b) mindestens einer organischen Verbindung, welche unter Einwirkung von aktinischer Strahlung eine Säure erzeugt, sowie

   (c) mindestens einer weiteren von (b) verschiedenen organischen Verbindung,

   **dadurch gekennzeichnet, daß**
   das Polymere (a) Einheiten der Formeln (I), (II) und (III)

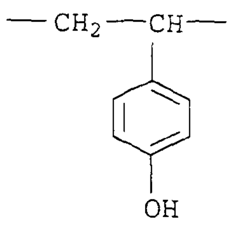

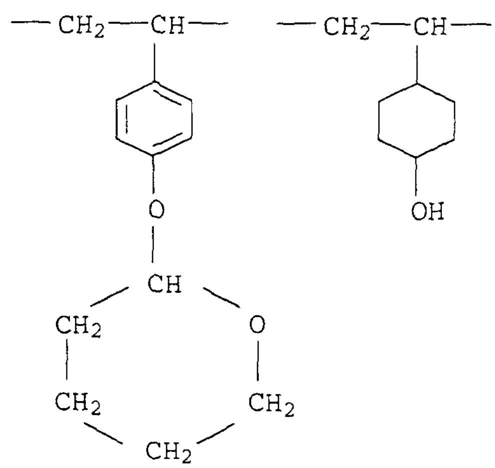

(I) (II) (III)

eingebaut enthält, mit der Maßgabe, daß

35-70 mol% Einheiten der Formel (I)
30-50 mol% Einheiten der Formel (II)und
0-15 mol% Einheiten der Formel (III)

als Struktureinheiten des Polymeren enthalten sind,
die organische Verbindung (b) ein Sulfoniumsalz der Formel (IV)

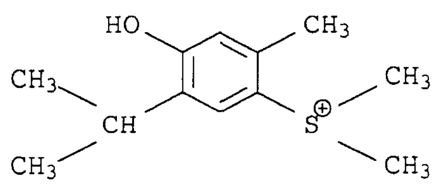

$CF_3SO_3^{\ominus}$

(IV)

ist und die organische Verbindung (c) der Formel (V)

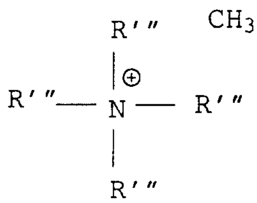

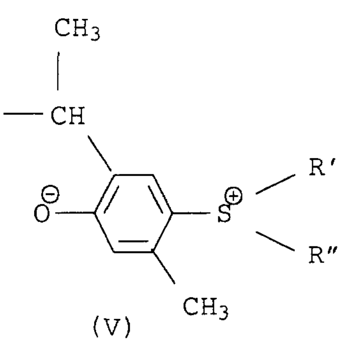

$CF_3SO_3^{\ominus}$

(V)

entspricht, worin R' mit R" untereinander gleich oder verschieden sind und für Alkylreste mit 1 bis 4 Kohlenstoffatomen stehen oder R' mit R'' miteinander über $CH_2$-Gruppen zu einem fünfgliedrigen Ring verknüpft sind und R''' für einen Alkylrest mit 1 bis 4 Kohlenstoffatomen steht.

**2.** Gemisch nach Anspruch 1, **dadurch gekennzeichnet, daß** in Formel (V) der organischen Verbindung (c) R', R'' und R''' für $CH_3$ stehen.

**3.** Gemisch nach Anspruch 1 oder 2, **dadurch gekennzeichnet, daß** es in Form einer Lösung in einem organischen Lösungsmittel oder Lösungsmittelgemisch vorliegt.

**4.** Gemisch nach Anspruch 1 oder 2, **dadurch gekennzeichnet, daß** die Komponenten (a), (b), und (c) in Mengen

von 90 bis 97,99 Gewichtsprozent (a),
von 2 bis 8 Gewichtsprozent (b) und
von 0,01 bis 2 Gewichtsprozent (c)

eingesetzt werden.

**5.** Verfahren zur Herstellung lichtempfindlicher Beschichtungsmaterialien, **dadurch gekennzeichnet, daß** ein strahlungsempfindliches Gemisch gemäß einem der Ansprüche 1 bis 4 eingesetzt wird.

**6.** Verfahren zur Herstellung von Reliefstrukturen durch Auftragen eines strahlungsempfindlichen Gemischs in einer Schichtdicke von 0,1 bis 5 µm auf ein in üblicher Weise vorbehandeltes Substrat, Trocknen bei Temperaturen von 70 bis 150°C, bildmäßiges Belichten mit aktinischem Licht, gegebenenfalls Erhitzen auf Temperaturen von 40 bis 160°C, und Entwickeln mit einer wäßrig-alkalischen Lösung, **dadurch gekennzeichnet, daß** ein strahlungsempfindliches Gemisch gemäß einem der Ansprüche 1 bis 4 eingesetzt wird.

## Claims

**1.** A positive-working radiation-sensitive mixture essentially consisting of

(a) at least one polymer which contains acid-labile groups and is insoluble in water but becomes soluble in aqueous alkaline solutions as a result of the action of acid,

(b) at least one organic compound which produces an acid under the action of actinic radiation and

(c) at least one further organic compound differing from (b),

wherein
the polymer (a) contains incorporated units of the formulae (I), (II) and (III)

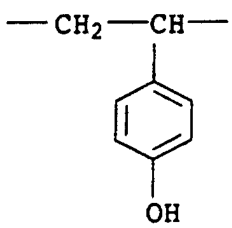
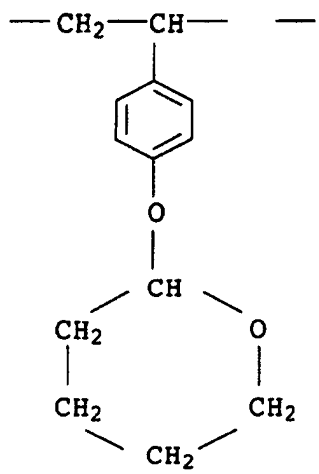
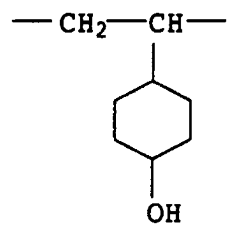

(I) (II) (III)

with the proviso that

35-70 mol% of units of the formula (I)
30-50 mol% of units of the formula (II) and
0-15 mol% of units of the formula (III)

are present as structural units of the polymer,
the organic compound (b) is a sulfonium salt of the formula (IV)

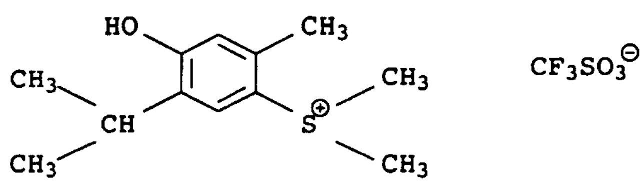

(IV)

and the organic compound (c) is of the formula (V)

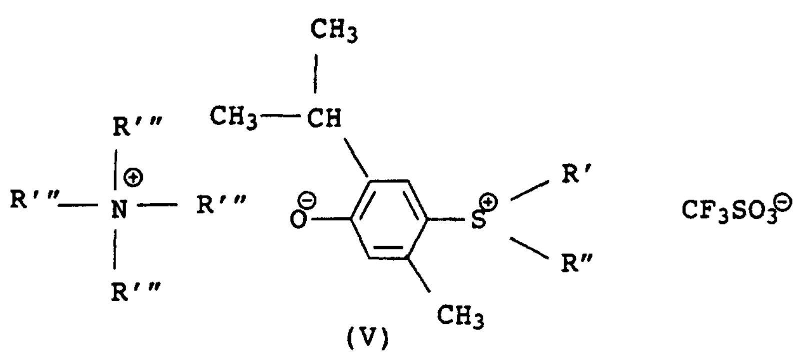

(V)

where R' and R" are identical or different and are each alkyl of 1 to 4 carbon atoms, or R' and R" are linked to one another via $CH_2$ groups to give a five-membered ring, and R'" is alkyl of 1 to 4 carbon atoms.

**2.** A mixture as claimed in claim 1, wherein, in the formula (V) of the organic compound (c), R', R" and R'" are each $CH_3$.

**3.** A mixture as claimed in claim 1, which is present in the form of a solution in an organic solvent or solvent mixture.

**4.** A mixture as claimed in claim 1, wherein the components (a), (b) and (c) are used in amounts of

from 90 to 97.99 percent by weight of (a),
from 2 to 8 percent by weight of (b) and
from 0.01 to 2 percent by weight of (c).

**5.** A process for the preparation of photosensitive coating materials, wherein a radiation-sensitive mixture as claimed in claim 1 is used.

**6.** A process for the production of relief structures by application of a radiation-sensitive mixture in a layer thickness of from 0.1 to 5 µm to a substrate pretreated in a conventional manner, drying at from 70 to 150°C, imagewise exposure to actinic light, if required heating to 40-160°C, and development with an aqueous alkaline solution, wherein a radiation-sensitive mixture as claimed in any of claims 1 to 4 is used.

## Revendications

**1.** Composition photosensible positive, constituée essentiellement:

(a) d'au moins un polymère contenant des groupements labiles vis-à-vis des acides, qui est insoluble dans l'eau, devient soluble dans des solutions aqueuses-alcalines, par l'action d'un acide,

(b) d'au moins une combinaison organique, qui produit un acide sous l'effet d'un rayonnement actinique, et

(c) d'au moins une autre combinaison organique différente de (b),

**caractérisée en ce que**:
le polymère (a) contient , incorporées, des unités des formules (I), (II) et (III),

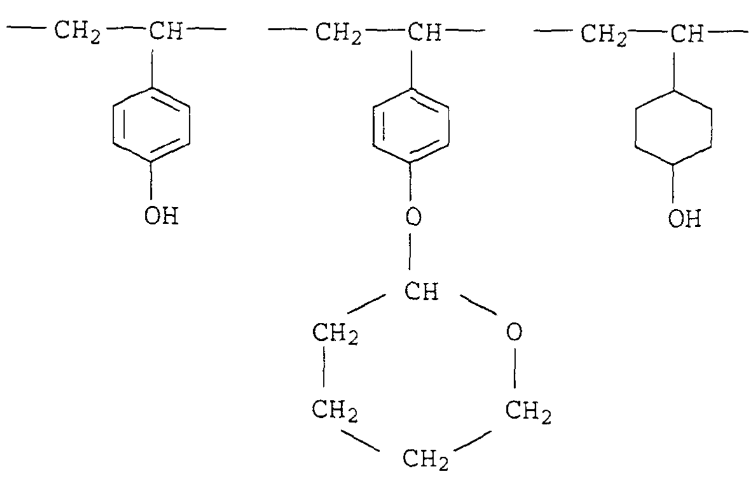

(I) (II) (III)

dans la mesure où:

35-70 mol % d'unités de formule I
30-50 mol % d'unités de formule II et

0 - 15 mol % d'unités de formule (III)

sont contenues comme unités structurelles du polymère,
la combinaison organique (b) est un sel de sulfonium de la formule (IV):

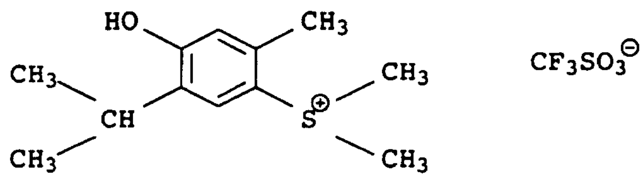

(IV)

et correspond à la combinaison organique (c) de formule (V) :

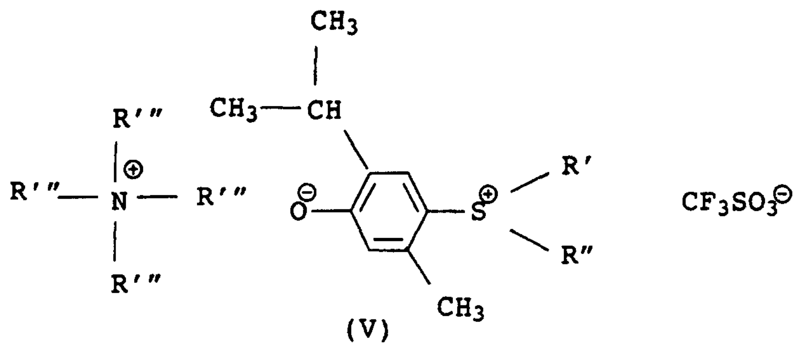

(V)

dans laquelle R' et R" sont identiques entre eux ou différents et représentent des restes alkyle de 1 à 4 atomes de carbone ou R' et R" sont reliés entre eux en un cycle à cinq chaînons par l'intermédiaire de groupes $CH_2$ et R"' est un reste alkyle de 1 à 4 atomes de carbone.

**2.** Composition la revendication 1, **caractérisée en ce que**, dans la formule (V) de la combinaison organique (c), R', R" et R"' sont $CH_3$.

**3.** Composition selon la revendication 1 ou 2, **caractérisée en ce qu'**elle existe sous forme d'une solution dans un solvant organique ou un mélange de solvants.

**4.** Composition selon la revendication 1 ou 2, **caractérisée en ce que** les composants (a), (b) et (c) sont utilisés dans les proportions :

de 90 à 97,99 % en poids (a)
de 2 à 8 % en poids (b) et
de 0,01 à 2 % en poids (c)

**5.** Procédé pour la fabrication de matières photosensibles, **caractérisé en ce que** l'on utilise une composition photosensible selon l'une des revendications 1 à 4.

**6.** Procédé pour la fabrication de structures en relief par application d'une composition photo-sensible en une épaisseur de couche de 0,1 à 5 µm sur un substrat prétraité de la manière habituelle, séchage à des températures de 70 à 150°C, éclairement à la manière d'une photographie avec une lumière actinique, le cas échéant chauffage à une température de 40 à 160°C et développement avec une solution aqueuse-alcaline, **caractérisé en ce que** l'on utilise une composition photo-sensible selon l'une quelconque des revendications 1 à 4.